# EUROPEAN PATENT SPECIFICATION

(11) **EP 1 984 958 B1**
(45) Date of publication and mention of the grant of the patent: **29.04.2009**
(21) Application number: 07734868.8
(22) Date of filing: 14.02.2007
(51) Int. Cl.: H01L 41/053, H01L 41/083

(54) **PIEZOELECTRIC DEVICE**
PIEZOELEKTRISCHE VORRICHTUNG
DISPOSITIF PIÉZOÉLECTRIQUE

(30) Priority: 14.02.2006 GB 0602956
(43) Date of publication of application: 29.10.2008
(73) Proprietor: Delphi Technologies, Inc., Troy, Michigan 48007 (US)
(72) Inventor: KIEFER, Joachim, R., D-66679 Losheim am See (DE)
(74) Representative: Gregory, John David Charles
(86) International application number: PCT/IB2007/001671
(87) International publication number: WO 2007/093919

(56) References cited:
- EP-A- 1 126 530
- WO-A-20/05001406
- DE-A1- 10 053 928
- DE-A1- 10 211 107
- FR-A1- 2 207 974
- GB-A- 2 403 166
- US-A- 5 936 004
- US-A1- 2005 255 370
- US-B1- 6 379 551
- US-B1- 6 552 472

## Description

### Technical Field

The invention relates to a piezoelectric device and, more particularly, to a piezoelectric device that is provided with an encapsulation means for protecting the device from the environment in which it operates. The invention has particular utility in the context of a piezoelectric device that is employed as an actuator in a piezoelectrically operated automotive fuel injector.

### Background to the Invention

It is known to use piezoelectric actuators in fuel injectors of internal combustion engines. Such piezoelectrically operable fuel injectors provide a high degree of control over the timing of injection events within the combustion cycle and the volume of fuel that is delivered during each injection event. This permits improved control over the combustion process which is essential in order to keep pace with increasingly stringent worldwide environmental regulations. Such fuel injectors may be employed in compression ignition (diesel) engines or spark ignition (petrol) engines.

In some injectors the piezoelectric actuator is surrounded by pressurised liquid fuel, usually diesel, biodiesel or gasoline. Typically, the liquid fuel is pressurised up to around 2000 bar or more. An injector of this type is described, for example, in the Applicant's European Patent No. 995901. In order to protect the piezoelectric actuator from damage and potential failure, the piezoelectric actuator must be isolated from this environment by at least a layer of barrier material, herein referred to as 'encapsulation means'. It is known to encapsulate the piezoelectric actuator with an inert fluoropolymer, which acts to prevent permeation of liquid fuel, and any water that may also be present as an unwanted contaminant in the fuel, into the structure of the actuator. To be successful as a means of encapsulating the piezoelectric actuator, the encapsulation means must also be able to withstand fuel permeation and water over the entire operational temperature range of between around -40°C and around 160°C.

Piezoelectric actuators comprising encapsulation means are disclosed by DE 100 53 928 A1, US 6 552 472 B1, and DE 102 11 107 A1. In DE 100 53 928 A1, the encapsulation comprises a metal or ceramics layer and a silicone layer. In US 6 552 472 B1, the device comprises a metal and elastomer encapsulation. In DE 102 11 107 A1, the encapsulation comprises a metal and ceramic housing, a water-absorbing medium and a water-transporting medium, wherein the media may be silica gels or oxides or chlorides.

In WO 2005 / 001406 A1 and EP 1 126 530 A2, the use of ion exchange materials as a bending member in piezoelectric bending members is disclosed.

### Summary of the Invention

It is against this background that the invention provides, in a first aspect, a piezoelectric device comprising a device body bearing encapsulation means to protectively encapsulate the device body wherein the encapsulation means includes an ion exchange membrane.

The invention is particularly suitable in the context of piezoelectrically operated automotive fuel injectors in which a piezoelectric device, preferably in the form of a piezoelectric actuator, is housed within the injector such that it is immersed in high pressure fuel. The invention provides the advantage that the actuator is provided with a membrane, or layer, that is impermeable to the through passage of an ionic species that may be present in the fuel and which may otherwise cause damage to the actuator, such damage being encouraged due to the presence of high electric fields generated by the device.

The ion exchange membrane may be selected to be reactive to cations, for example a cation exchange membrane, or to be reactive to anions, for example an anion exchange membrane. It should be noted that the terms 'membrane' and 'layer' are used interchangeably, herein, in reference to the ion exchange membrane.

In an alternative embodiment, the encapsulation means includes a bipolar ion exchange membrane, that is to say the ion exchange membrane prevents the through passage of anions and cations. The bipolar ion exchange membrane may be in the form of laminated first and second unipolar membranes which sandwich an inert intermediate layer. Alternatively, the bipolar ion exchange membrane may be a single layer.

The ion exchange membrane may comprise solely of an ion exchange material (i.e. a homogeneous membrane) or, alternatively, may comprise an ion exchange material embedded within an inert substrate (i.e. a heterogeneous membrane).

In order to provide further protection for the actuator, for example from elements of pressurised fuel in which it may be immersed, in use, the encapsulation means may further include a polymeric insulating layer outwardly adjacent the ion exchange membrane.

In a second aspect, the invention provides a fuel injector comprising an injector body and a piezoelectric device as set out above.

### Brief Description of the Drawings

So that it may be more readily understood, the invention will now be described, by way of example only, with reference to the following drawings in which:
Figure 1 is a perspective view of a known piezoelectric actuator; and
Figure 2 is a cross section view of the piezoelectric actuator in Figure 1 having an encapsulation means in accordance with an embodiment of the invention.

### Detailed Description of the Preferred Embodiment

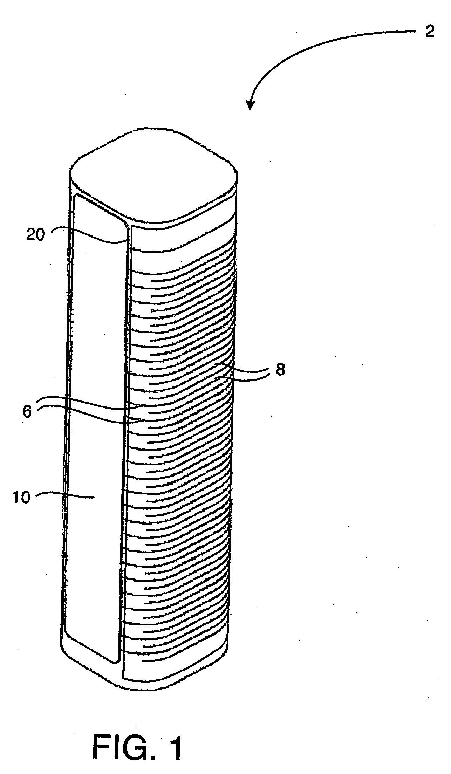

Figure 1 is a perspective view of a multilayered piezoelectric actuator 2. The actuator 2 is formed from a stack of piezoelectric layers or elements 4 that are separated from each other by a plurality of internal electrodes 6, 8. Typically, the piezoelectric elements 4 are formed from a ferroelectric material such as lead zirconate titanate, which is known by those skilled in the art as PZT. It should be mentioned at this point that the structure of the actuator depicted in Figure 1 is illustrative only and in practice the actuator 2 would include a greater number of layers and electrodes (typically in the order of hundreds) than those shown and with a much smaller spacing.

The internal electrodes 6, 8 are divided into two groups: a positive group of electrodes (only two of which are identified at 6) and a negative group of electrodes (only two of which are identified at 8). The positive group of electrodes 6 are interdigitated with the negative group of electrodes 8, with the electrodes of the positive group connecting with a positive external electrode 10 of the actuator 2 and the negative group of electrodes connecting with a negative external electrode (not shown) on the opposite side of the actuator 2 to the positive external electrode 10.

The construction of the actuator results in the presence of active regions between internal electrodes of opposite polarity. The application of a voltage across the external electrodes causes the active regions to expand resulting in an extension of the longitudinal axis of the actuator 2.

In use, the positive and negative external electrodes receive an applied voltage that is arranged to produce an electric field having a rapidly changing strength between adjacent interdigitated internal electrodes 6, 8. Varying the applied field causes the actuator 2 to extend and contract along the direction of the applied field in a cyclical manner.

The high electrical field applied to the piezoelectric elements 4 causes a risk of electrical arcing between the side edges of the internal electrodes of opposite polarity. To prevent such arcing, the actuator 2 is also provided with an electrical passivation layer 20 that covers substantially the entire surface of the stack 4, except for the external electrodes 10. The function of the passivation layer 20 is to insulate the edges of the internal electrodes 6, 8 that emerge at the stack surface and so guard against electrical arcing due to the high voltages applied to the internal electrode layers 6, 8.

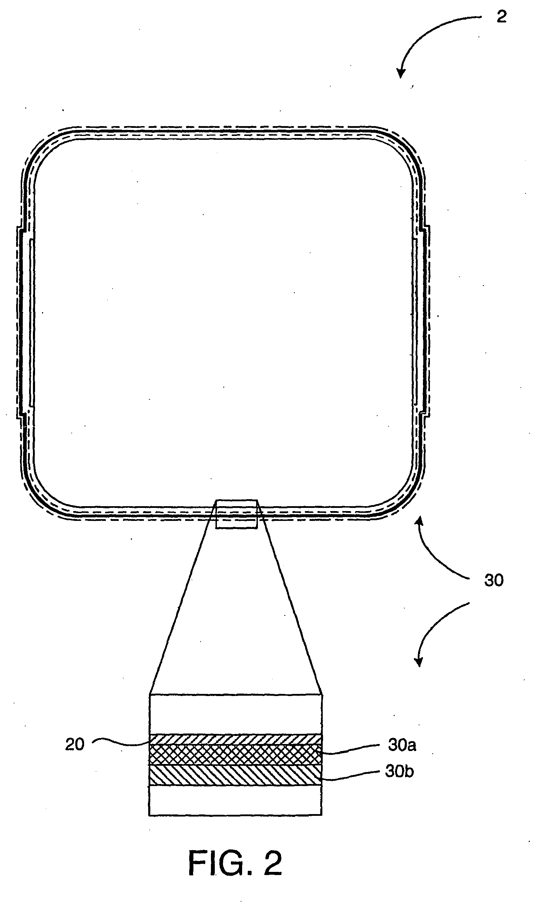

Figure 2 shows in detail the actuator 2 of Figure 1 in lateral cross section having an encapsulation means 30 applied thereto in accordance with the invention. In this embodiment, the encapsulation means 30 includes an ion exchange membrane 30a that is applied to the actuator 2 with a standard grade electrical adhesive so as to cover substantially the entire surface of the actuator 2. The encapsulation means 30 also includes a layer 30b of polymeric material, for example fluorinated polymer such as PTFE, FEP, PFA, ETFE or PVDF, which is applied to the actuator 2 outwardly adjacent the ion exchange membrane 30a so as to completely cover the membrane. The encapsulation means may also be formed from a semi-crystalline polymer so as to offer fuel resistance such as PPS, PES, PEEK and PBI.

The ion exchange membrane 30a is selected to be reactive to cations and, as such, prevents the transportation of cations across the encapsulation means 30. Without the cation exchange membrane 30a the encapsulation means would be ineffective at sequestering cations present in the fuel filled passages of the injector in which the actuator is housed, in use, and so it would therefore be possible for cations to penetrate into the actuator 2 and cause damage thereto. The presence of ionic species is a particular problem since the high electric field strengths generated by the piezoelectric actuator has the affect of accelerating the ionic species in creasing their migration into the structure of the actuator.

The use of ion exchange membranes is known for example in desalination processes and the production of acids and basic solutions. Cation exchange membranes typically have sulfonic acid groups attached to a polymeric backbone suitably comprising fluorinated polymers such as PTFE, ETFE, FEP or alternatively polyetherketones. Cations which enter the membrane 30a can exchange with the protons of the acid functional groups present therein. The ion retention of the membrane 30a is characterized by the so-called ion exchange capacity, given in meq/g. Typical ion exchange capacities for sulfonated cation exchange membranes are in the order of 2 meq/g. Ion transport is accelerated when in the presence of water by a so called 'vehicle-mechanism'. In use, cation exchange membranes release protons, which can generate hydrogen in small quantities. Hydrogen ions are not thought to create a conductive pathway in the materials used in the construction of piezoelectric actuators.

Cation-exchange membranes are mostly available in form of films or tubes. Cation-exchange membranes are suitable for retaining and exchanging cations such as K⁺, Na⁺, Ca²⁺ which are naturally dissolved in water.

The cation exchange membrane 30a is bonded to the actuator by way of a standard electrical grade adhesive. Standard grade electrical adhesive can suitably be used when applying the barrier coating to piezoelectric actuators which may or may not have a passivation layer applied thereto.

The polymeric layer 30b acts to provide a protective barrier for the actuator 2 from the highly pressurised fluid in which the actuator is immersed, in use. The polymeric layer is preferably applied as a heat shrink tube which has an initial diameter that is larger than the outer dimensions of the stack to enable the actuator to be received therein. Heating the tube causes the diameter of the tube to decrease so as to shrink to fit tightly the profile of the actuator 2. The heat shrink tube is preferably in the form of a fluoropolymer such as PTFE, FEP, PFA, ETFE or PVDF.

In an alternative embodiment, the ion exchange membrane 30a is selected to be reactive to anions. Such anion exchange membranes typically contain ammonium hydroxide (NH₄OH) functional groups. Anion exchange membranes can prevent passage of anions such as chloride ions (Cl⁻), which could generate potentially harmful silver chloride (AgCl) or other conductive phase within the piezoelectric stack.

Higher ion exchange capacities can be achieved in crosslinked polybenzimidazole-vinylphosphonic acid (PBI-VPA) membranes. In such membranes the polymer backbone is a thermally and chemically resistant polybenzimidazole material. Ion transport and diffusion can be further controlled in this material by the amount of crosslinking - either via electrons or chemical functionalities.

In order to provide improved ionic protection, an alternative embodiment provides a combination of anionic and cationic exchange functionality. In one variant, dual ionic exchange functionality is provided by interleaving one or more anion exchange membranes and one or more cation exchange membranes with inert PTFE polymer layers in order to build up a multilayer encapsulation assembly. The layers are bonded together using techniques known in the art of polymerics-to-polymerics bonding. The appropriate thickness for each ion exchange membrane and PTFE layer can vary between around 1 µm and around 500 µm depending on the necessary requirements of the barrier coating. Preferably, the layer thickness for the ion exchange membranes is around 200 µm.

In a further variant, dual ion exchange functionality is provided by a bipolar ion exchange membrane. The bipolar ion-exchange membrane comprises two layers of thermoplastic homogeneous synthetic organic polymeric material, one cationic and the other anionic, united over the whole common interface. Bipolar laminated membranes can be manufactured with both layers derived from polythene-styrene graft polymer films or glass fibre-reinforced PTFE, for example.

By virtue of the invention, the actuator 2 is provided with improved protection from moisture bearing environments in which it is located, in use. In combination, the encapsulation means provides resistance to permeation of liquid components (e.g. fuel and water) and also ionic species (e.g. aqueous solutes). As a result the encapsulating means exhibits greatly improved performance and reduces the tendency for such an encapsulated actuator to fail.

It should be appreciated that various modifications may be made to the above embodiments without departing from the invention as defined by the appended claims. For example, although it has been described above that the piezoelectric actuator includes an encapsulation means having a single ionic exchange membrane, it should be appreciated that this need not be the case and that multiple layers of bipolar and/or unipolar ion exchange membranes can be used to form a multilayer ion membrane assembly. Such an assembly can also contain inert intervening layered films, for example made from PTFE. In this way the invention provides a piezoelectric actuator with a multilayered encapsulation means in which ion exchange membranes alternate with layers of inert material. Such an arrangement may be advantageous in extending the length of time that the actuator is protected from ionic elements present within fuel.

## Claims

1. A piezoelectric device (2) comprising a device bod bearing encapsulation means (30) to protectively encapsulate the device body, **characterised in that** the encapsulation means (30) includes an ion exchange membrane (30a).

2. The piezoelectric device (2) of claim 1, wherein the ion exchange membrane (30a) is selected to be reactive to cations.

3. The piezoelectric device (2) of claim 1, wherein the ion exchange membrane (30a) is selected to be reactive to anions.

4. The piezoelectric device (2) of claim 1, wherein the ion exchange membrane (30a) is a bipolar membrane.

5. The piezoelectric device (2) of claim 4, wherein the bipolar membrane comprises laminated first and second unipolar membranes which sandwich an inert intermediate layer.

6. The piezoelectric device (2) of any one of the preceding claims, wherein the ion exchange membrane (30a) is homogenous.

7. The piezoelectric device (2) of any one of claims 1 to 5, wherein the ion exchange membrane (30a) is heterogeneous.

8. The piezoelectric device (2) of any one of the preceding claims, wherein the encapsulation means (30a) further includes a polymeric insulating layer (30b) outwardly adjacent the ionic exchange membrane (30a).

9. A fuel injector comprising an injector body and a piezoelectric device (2) according to any one of the preceding claims.

## Patentansprüche

1. Piezoelektrische Vorrichtung (2), umfassend einen Vorrichtungskörper, der ein Einkapselungsmittel (30) zum schützenden Kapseln des Vorrichtungskörpers trägt, **dadurch gekennzeichnet, dass** das Einkapselungsmittel (30) eine Ionenaustauschmembran (30a) aufweist.

2. Piezoelektrische Vorrichtung (2) nach Anspruch 1, bei der die Ionenaustauschmembran (30a) so gewählt ist, dass sie auf Kationen reagierend ist.

3. Piezoelektrische Vorrichtung (2) nach Anspruch 1, bei der die Ionenaustauschmembran (30a) so gewählt ist, dass sie auf Anionen reagierend ist.

4. Piezoelektrische Vorrichtung (2) nach Anspruch 1, bei der die Ionenaustauschmembran (30a) eine bipolare Membran ist.

5. Piezoelektrische Vorrichtung (2) nach Anspruch 4, bei der die bipolare Membran geschichtete erste und zweite unipolare Membranen umfasst, die eine inerte Zwischenschicht zwischen sich einschließen.

6. Piezoelektrische Vorrichtung (2) nach einem der vorhergehenden Ansprüche, bei der die Ionenaustauschmembran (30a) homogen ist.

7. Piezoelektrische Vorrichtung (2) nach einem der Ansprüche 1 bis 5, bei der die Ionenaustauschmembran (30a) heterogen ist.

8. Piezoelektrische Vorrichtung (2) nach einem der vorhergehenden Ansprüche, bei der das Einkapselungsmittel (30a) ferner eine polymere Isolierschicht (30b) auswärts neben der Ionenaustauschmembran (30a) aufweist.

9. Kraftstoffeinspritzventil, umfassend einen Einspritzventilkörper und eine piezoelektrische Vorrichtung (2) nach einem der vorhergehenden Ansprüche.

## Revendications

1. Dispositif piézo-électrique (2) comprenant un corps de dispositif portant des moyens d'encapsulation (30) pour encapsuler le corps de dispositif en le protégeant, **caractérisé en ce que** les moyens d'encapsulation (30) incluent une membrane échangeuse d'ions (30a).

2. Dispositif piézo-électrique (2) selon la revendication 1, dans lequel la membrane échangeuse d'ions (30a) est choisie pour être réactive aux cations.

3. Dispositif piézo-électrique (2) selon la revendication 1, dans lequel la membrane échangeuse d'ions (30a) est choisie pour être réactive aux anions.

4. Dispositif piézo-électrique (2) selon la revendication 1, dans lequel la membrane échangeuse d'ions (30a) est une membrane bipolaire.

5. Dispositif piézo-électrique (2) selon la revendication 4, dans lequel la membrane bipolaire comprend une première et une seconde membrane unipolaire stratifiées qui prennent en sandwich une couche intermédiaire inerte.

6. Dispositif piézo-électrique (2) selon l'une des revendications précédentes, dans lequel la membrane échangeuse d'ions (30a) est homogène.

7. Dispositif piézo-électrique (2) selon l'une quelconque des revendications 1 à 5, dans lequel la membrane échangeuse d'ions (30a) est hétérogène.

8. Dispositif piézo-électrique (2) selon l'une quelconque des revendications précédentes, dans lequel les moyens d'encapsulation (30a) incluent en outre une couche isolante polymère (30b) extérieurement adjacente à la membrane échangeuse d'ions (30a).

9. Injecteur de carburant comprenant un corps d'injecteur et un dispositif piézo-électrique (2) selon l'une quelconque des revendications précédentes.
